# FASCICULE DE BREVET EUROPEEN

(11) **EP 2 866 254 B1**
(45) Date de publication et mention de la délivrance du brevet: **19.04.2017**
(21) Numéro de dépôt: 14178355.5
(22) Date de dépôt: 24.07.2014
(51) Int. Cl.: H01L 21/768, H01L 21/288, C23C 18/16, C23C 18/18

(54) **Procédé de réalisation d'un revêtement métallique sur une surface**
Verfahren zur Herstellung einer Metallbeschichtung auf einer Oberfläche
Method for producing a metal coating on a surface

(30) Priorité: 30.07.2013 FR 1357547
(43) Date de publication de la demande: 29.04.2015
(73) Titulaire: COMMISSARIAT À L'ÉNERGIE ATOMIQUE ET AUX ÉNERGIES ALTERNATIVES, 75015 Paris (FR)
(72) Inventeur: Baillin, Xavier, 38920 Crolles (FR); Gaspuratto, Didier, 38220 Notre Dame De Mesage (FR)
(74) Mandataire: Decobert, Jean-Pascal

(56) Documents cités:
- EP-A1- 1 387 169
- JP-A- 2011 249 365
- US-A1- 2001 044 114
- US-A1- 2005 158 763
- US-A1- 2006 254 504

## Description

### DOMAINE DE L'INVENTION

La présente invention est relative à un dispositif microélectronique. Elle concerne notamment la réalisation d'un revêtement à base de métal sur une surface notamment tridimensionnelle d'un substrat.

### ARRIERE-PLAN TECHNOLOGIQUE

L'intégration tridimensionnelle (3D) devient une voie d'exploration très suivie en microélectronique. Elle permet notamment d'assembler entre elles des puces selon un axe vertical favorisant ainsi la réalisation de composants toujours plus compacts et performants; la longueur des interconnexions étant réduite par rapport à un assemblage classique. Il convient dès lors de maitriser pour cette technologie tridimensionnelle, l'étape de dépôt de matériaux 3D tels que les isolants ou les métaux.

En outre, les connexions électriques traversantes plus communément désignées sous les acronymes en anglais de « TSV » pour « Through-Silicon Vias » lorsque le substrat est en silicium, « TGV » pour « Through-Glass Vias » lorsque le substrat est en verre, ou encore « TPV » pour Through-Polymer Vias » lorsque le substrat est en polymère, sont utilisées dans les composants microélectroniques afin de connecter une face d'un composant à sa face opposée.

Compte tenu de l'augmentation de la densité des connexions électriques, il devient indispensable de réduire leur dimension dans le plan, et notamment leur diamètre (de l'ordre de quelques microns), tout en conservant une profondeur de l'ordre d'une centaine de microns. Les étapes de dépôt d'isolants et de matériaux conducteurs deviennent dès lors des verrous technologiques.

La gravure du substrat lorsqu'il est en silicium est réalisée généralement par gravure ionique réactive profonde (acronyme DRIE en anglais pour « Deep Reactive Ion Etching »). L'isolation des parois d'un via est obtenue par un dépôt d'un isolant (par exemple, du dioxyde de silicium SiO₂) généralement par la méthode de déposition chimique en phase vapeur (acronyme CVD, en anglais pour « Chemical Vapor Deposition »). En fonction de la température maximale admissible par le substrat, plusieurs procédés existent dans une gamme de température comprise entre 150°C et 400°C. Si le substrat le permet, une oxydation thermique peut être envisagée (température supérieure à 800°C par exemple). La déposition du conducteur métallique s'effectue en trois étapes : la première consiste à déposer une couche d'accroche sur l'isolant (par exemple du titane sur le SiO₂), la seconde à déposer une couche barrière à la diffusion (nickel ou nitrure de titane par exemple), la troisième à déposer une couche de métal (cuivre ou or par exemple) qui va servir de couche de germination (en anglais « seed layer ») ou pour la croissance d'un dépôt par électrodéposition (cuivre par exemple).

Toute la problématique, lorsque le facteur de forme (Profondeur du via par rapport au diamètre du via, aussi dénommé « Aspect ratio » en anglais et noté AR) augmente, est de trouver des solutions pour obtenir un dépôt conforme, c'est-à-dire couvrant uniformément les parois du via.

En outre, les couches formées par ces techniques traditionnelles de dépôt ne sont pas conformes, et ne présentent donc pas une épaisseur uniforme en tout point de la surface du substrat. Les flancs des tranchées et des vias peuvent notamment être recouverts d'une épaisseur insuffisante de la couche, provoquant alors un remplissage ultérieur imparfait présentant des défauts de matière (appelées « voids » en anglais). De plus, les couches réalisées sur les flancs des motifs présentent par nature une adhérence différente de celle déposée sur la surface plane du substrat (haut et fond des tranchées et des vias). Ceci peut conduire à des performances de fiabilité, telles que la résistance à l'électromigration, amoindries. En d'autres termes, le défaut de conformité ne se révèle pas seulement par des différences d'épaisseur ; des défauts de continuité et d'adhérence de la couche sur les flancs des tranchées et des vias peuvent aussi en résulter.

Ces inconvénients rendent très délicat l'emploi de la technologie PVD dans les générations avancées de circuits intégrés où les dimensions transversales des tranchées et des vias sont très faibles (de l'ordre de quelques dizaines de nanomètres) et où les facteurs de forme peuvent être importants. Concernant le dépôt physique en phase vapeur (acronyme PVD en anglais pour « Physical Vapor Deposition »), le procédé atteint ses limites pour un rapport de forme de l'ordre de 10 pour 1 (noté 10:1). Le dépôt métallique par CVD trouve aussi des limites dans le rapport de forme, mais surtout dans le coût technologique. Au même titre, le dépôt de couches atomiques (ALD en anglais pour « Atomic Layer Deposition ») est une alternative coûteuse (procédé lent) par rapport au procédé de dépôt chimique en phase vapeur. La solution semble donc aujourd'hui se trouver dans les procédés par voie humide qui sont les mieux adaptés pour répondre au cahier des charges: facteur de forme et coût.

Dans ce contexte, les solutions par dépôt d'une couche en milieu liquide présentent un avantage en mettant en jeu un procédé par électro-greffage (« electrografting » en anglais) d'un précurseur organique sur un substrat conducteur ou semi-conducteur. Il est alors possible de réaliser un empilement de couches par dépôt successif d'une couche d'isolation, puis d'une couche barrière à la diffusion suivie d'une couche de germination. L'électro-greffage consiste en un procédé de dépôt par voie humide reposant sur l'initiation puis la polymérisation électro-induite de monomères électro-actifs. Le document FR_A_2933425 décrit un procédé de réalisation d'un film isolant électrique par électro-greffage ainsi que le dépôt d'une barrière de diffusion au cuivre. Ces procédés permettent d'obtenir des films conformes, d'épaisseur comprise entre quelques nanomètres et 500 nanomètres pour des rapports de forme pouvant atteindre 20:1. Le procédé décrit dans le document FR_A_2933425 consiste à déposer par électro-greffage un film organique sur une surface conductrice ou semi-conductrice. L'électro-greffage est obtenu en immergeant la surface conductrice ou semi-conductrice dans une solution contenant le ou les précurseurs organiques et en appliquant un potentiel électrique sur ladite surface. On connait également le document US 2006/0254504 A1 qui divulgue la réalisation de dépôts de couches distinctes en milieu aqueux.

Les documents US 2005/0158763 A1, JP 2011-249365 A et US 2001/0044114 A1 divulguent, eux, l'utilisation d'un précurseur organique sour la forme de brin d'ADN afin de réaliser des dépôts de couches métalliques en milieu aqueux.

Un objet de la présente invention est de proposer un procédé de dépôt alternatif qui pourra être utilisé, par exemple, pour la réalisation de via traversant dont le rapport de forme peut atteindre, par exemple, 50:1.

Par ailleurs, il peut être particulièrement avantageux de proposer une solution pour pouvoir tapisser d'au moins une monocouche de nanoparticules des formes géométriques, par exemple, en trois dimensions.

Il serait également avantageux de proposer un procédé permettant de former un revêtement uniforme et homogène sur une surface, et par exemple tridimensionnelle, tout en permettant d'obtenir un rapport de forme élevé tel que 50:1.

La présente invention propose d'apporter une solution pour atteindre au moins l'un de ces objectifs.

### RESUME DE L'INVENTION

L'invention concerne, selon un aspect de modes de réalisation, un procédé de réalisation d'un revêtement à base de métal sur au moins une portion de la surface d'un substrat d'un dispositif microélectronique caractérisé en ce qu'il comprend, à partir d'un brin d'acide nucléique modifié comprenant une structure de brin d'acide nucléique, au moins une nanoparticule à base de métal et/ou un atome métallique et au moins une fonction chimique, au moins une étape de fixation du brin d'acide nucléique modifié sur la portion de la surface du substrat par l'intermédiaire d'au moins une fonction chimique.

Selon l'invention, la notion de « micro-dispositif » intègre celle de « nano-dispositif ». Par ailleurs, on entend par brin d'acide nucléique aussi bien un brin simple qu'un brin double.

Compte tenu du fait qu'il est possible de synthétiser de l'acide nucléique qui va comporter au sein d'un double brin (double hélice), un atome métallique ou un chapelet d'atomes métalliques qui peuvent être de natures chimiques différentes, ou encore à l'extrémité d'un simple brin une nanoparticule à base de métal, il apparaît donc possible de réaliser des dépôts à base de métal à partir de cet acide nucléique métallisé en son sein et/ou en périphérie.

Le procédé met ainsi en jeu des précurseurs obtenus à partir de brins d'acide nucléique modifiés. Il s'agit donc d'un procédé par voie humide qui va permettre de tapisser les parois par exemple d'une cavité (notamment d'un via) et/ou d'un relief (notamment d'un plot), par exemple, par des précurseurs de taille nanométrique présents sur les brins d'acide nucléique modifiés. De manière particulièrement avantageuse, ceux-ci vont permettre, par exemple, de réaliser des couches d'isolant, de barrière à la diffusion et la couche de germination métallique pour un dépôt par voie chimique (« electroless »), qui pourra être ensuite suivi d'une électrodéposition chimique classique (« Electro Chemical Déposition », ECD). Le procédé met en jeu des brins d'acide nucléique comprenant à la fois des nanoparticules et/ou des atomes ainsi qu'au moins une fonction chimique qui va permettre de greffer le brin sur la surface tridimensionnelle. Avantageusement, l'invention ne s'appliquera pas seulement aux surfaces tridimensionnelles, mais également par exemple aux surfaces bidimensionnelles.

Avantageusement, le procédé permet de tapisser d'au moins une monocouche de nanoparticules des formes géométriques, par exemple, en trois dimensions.

Avantageusement, l'invention permet d'obtenir un rapport de forme élevé.

En outre, l'invention ne nécessite pas obligatoirement l'action extérieure d'un champ électrique. Néanmoins, selon un mode de réalisation particulier on peut avantageusement utiliser un champ magnétique extérieur lorsque la nanoparticule ou l'atome métallique est magnétique, comme par exemple le fer (Fe), le cobalt (Co), le nickel (Ni).

L'invention concerne également, suivant d'autres aspects, l'utilisation d'au moins un brin d'acide nucléique modifié comprenant une structure de brin d'acide nucléique (ou squelette), au moins une nanoparticule à base de métal et/ou un atome métallique, configurée pour former un revêtement à base de métal sur au moins une portion de la surface d'un substrat.

### BREVE INTRODUCTION DES FIGURES

D'autres caractéristiques, buts et avantages de la présente invention ressortiront mieux de la description détaillée de modes de réalisation de cette dernière, qui sont illustrés par les dessins d'accompagnement suivants dans lesquels :
La FIGURE 1 illustre une vue schématique d'un double brin d'acide nucléique modifié de type ADN sur lequel a préalablement été greffé(e), en périphérie du double brin, et notamment sur la structure du brin, un atome ou une nanoparticule.
La FIGURE 2 illustre une vue schématique d'un double brin d'acide nucléique modifié sur lequel a préalablement été greffé(e) sur un structure du brin, entre deux bases, un atome ou une nanoparticule.
Les FIGURES 3A et 3B sont des représentations schématiques d'un simple brin d'acide nucléique modifié sur lequel ont préalablement été greffées, à une première extrémité du brin, une nanoparticule et, à l'autre extrémité, une fonction chimique.
La FIGURE 4 illustre l'étape de formation d'un motif d'interconnexion sur le substrat.
La FIGURE 5 illustre l'étape de traitement de la surface tridimensionnelle du substrat.
La FIGURE 6 illustre une étape de greffage d'au moins un brin d'acide nucléique modifié, comprenant la structure du brin, au moins un atome ou une nanoparticule et une fonction chimique.
La FIGURE 7 illustre une étape de chauffage configurée pour détruire partiellement ou totalement la structure du brin d'acide nucléique modifié.
La FIGURE 8 illustre l'étape de réalisation d'un dépôt électrochimique sur le revêtement.
Les FIGURES 9A et 9B illustre un exemple de surface tridimensionnelle sur lequel le revêtement selon la présente invention peut être réalisé en assurant une uniformité de la couche et une répartition sur toute la surface.
La FIGURE 10A illustre un exemple de surface tridimensionnelle d'un substrat sur lequel a été préalablement réalisée une cavité. Les flancs de la cavité sont recouverts d'un film hydrophile ou hydrophobe permettant aux brins d'acide nucléique modifiés de venir se fixer.
La FIGURE 10B illustre un exemple de surface tridimensionnelle d'un substrat sur lequel a été préalablement réalisée une cavité. Suite à une irradiation par rayons ultraviolets, seuls les flancs de la cavité protégés des rayons sont recouverts de brins d'acide nucléique modifiés.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches et films ne sont pas représentatives de la réalité.

### DESCRIPTION DETAILLEE

Il est précisé que dans le cadre de la présente invention, le terme « sur » ne signifie pas obligatoirement « au contact de ». Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant soit directement à son contact, soit en étant séparée d'elle par un film, encore une autre couche ou un autre élément.

Avant d'entamer une revue détaillée de modes de réalisation de l'invention, sont énoncées ci-après des caractéristiques optionnelles qui peuvent éventuellement être utilisées en association ou alternativement :
- L'étape de fixation du brin d'acide nucléique modifié est réalisée par l'intermédiaire de la fonction chimique.
- A l'issue de l'étape de fixation de la fonction chimique, une étape de destruction au moins partielle de la structure (ou squelette) de brin d'acide nucléique et de la fonction chimique.
- L'étape de destruction au moins partielle de la structure de brin d'acide nucléique et/ou de la fonction chimique comprend une étape de chauffage configurée de sorte à détruire partiellement ou totalement la structure de brin d'acide nucléique et/ou de la fonction chimique.
- La au moins portion de surface du substrat est une surface tridimensionnelle.
- Ladite portion de surface est choisie parmi une cavité et/ou un relief.
- Ladite portion de surface est une cavité et la cavité présente une profondeur supérieure à sa largeur.
- L'étape de fixation du au moins un brin d'acide nucléique modifié sur la portion de la surface du substrat est obtenue par la mise en contact de la surface du substrat avec un bain comprenant au moins un brin d'acide nucléique modifié.
- La portion de la surface du substrat comprend un groupement chimique configuré de sorte à coopérer avec la fonction chimique fixée sur la structure du au moins un brin d'acide nucléique modifié.
- Plusieurs étapes de fixation de brins d'acide nucléique modifiés sont réalisées.
- Les brins d'acide nucléique modifiés sont identiques ou différents par la structure de leurs brins respectifs et/ou par leurs fonctions chimiques respectives et/ou par la nature et/ou les dimensions des nanoparticules à base de métal et/ou des atomes métalliques. Avantageusement, les brins d'acide nucléique modifiés sont de nature variable.
- Après les étapes de fixation de brins d'acide nucléique modifiés, une seule étape de destruction des structures de brins d'acide nucléique est réalisée.
- Préalablement à ladite au moins une étape de fixation de la fonction chimique du au moins un brin d'acide nucléique modifié sur la portion de la surface du substrat, une étape de dépôt d'une couche de greffage sur au moins la portion de la surface du substrat.
- La couche de greffage est déposée sur toute la surface du substrat.
- La portion de la surface du substrat ou la couche de greffage comprend un premier groupement chimique ou un matériau hydrophile ou hydrophobe.
- La fonction chimique comprend un deuxième groupement chimique hydrophile ou hydrophobe.
- Le revêtement à base de métal fait partie d'un via.
- L'atome métallique est choisi parmi le cuivre, le nickel, l'aluminium, le palladium, l'or, l'argent.
- La nanoparticule métallique est choisie parmi un métal, un oxyde métallique, un nitrure métallique, un carbure métallique.
- Préalablement à l'étape de fixation de la fonction chimique du au moins un brin d'acide nucléique modifié sur la portion de la surface du substrat, une étape d'irradiation par rayons ultra-violets de la portion de la surface du substrat destinée à recevoir le revêtement à base de métal.
- Préalablement à l'étape de fixation de la fonction chimique du au moins un brin d'acide nucléique modifié sur la portion de la surface du substrat, une étape d'irradiation par rayons ultra-violets de toute la surface du substrat, exceptée la portion destinée à recevoir le revêtement à base de métal.
- Au moins une nanoparticule à base de métal ferromagnétique est configurée pour former, sous l'action d'un champ magnétique, un revêtement à base de métal ferromagnétique sur une portion de la surface d'un substrat.
- Au moins un premier brin d'acide nucléique modifié comprenant au moins une première nanoparticule à base de métal et/ou un premier atome métallique et au moins un deuxième brin d'acide nucléique modifié comprenant au moins une deuxième nanoparticule à base de métal et/ou un deuxième atome métallique, sont configurés de sorte à ce que la première et/ou la deuxième nanoparticule(s) et le premier et/ou le deuxième atome(s) métallique(s) forment un revêtement à base d'un alliage métallique ou d'un composite sur une portion de la surface d'un substrat. Avantageusement, un composé dans l'invention est, par exemple, un mélange de métal, d'oxyde, de carbure et/ou de nitrure de métal.
- Au moins un premier brin d'acide nucléique modifié comprenant au moins une première nanoparticule à base d'un premier métal et au moins un deuxième brin d'acide nucléique modifié comprenant au moins une deuxième nanoparticule à base d'un deuxième métal, sont configurés de sorte à ce que la première et la deuxième nanoparticules forment un revêtement bi-couche composé d'un dépôt à base du premier métal de la première nanoparticule recouvert par un dépôt du deuxième métal de la deuxième nanoparticule sur une portion de la surface d'un substrat.

Un aspect non limitatif avantageux est de permettre des dépôts dans des cavités, éventuellement avec des rapports de forme élevés (par exemple de 50) en mettant en oeuvre :
- Une solution de dépôt, c'est-à-dire un dépôt par voie liquide ;
- Un gabarit réalisé à partir d'un brin d'acide nucléique, ce gabarit ayant une dimension nanométrique ;
- Une fonction chimique permettant de greffer le gabarit sur la surface souhaitée.

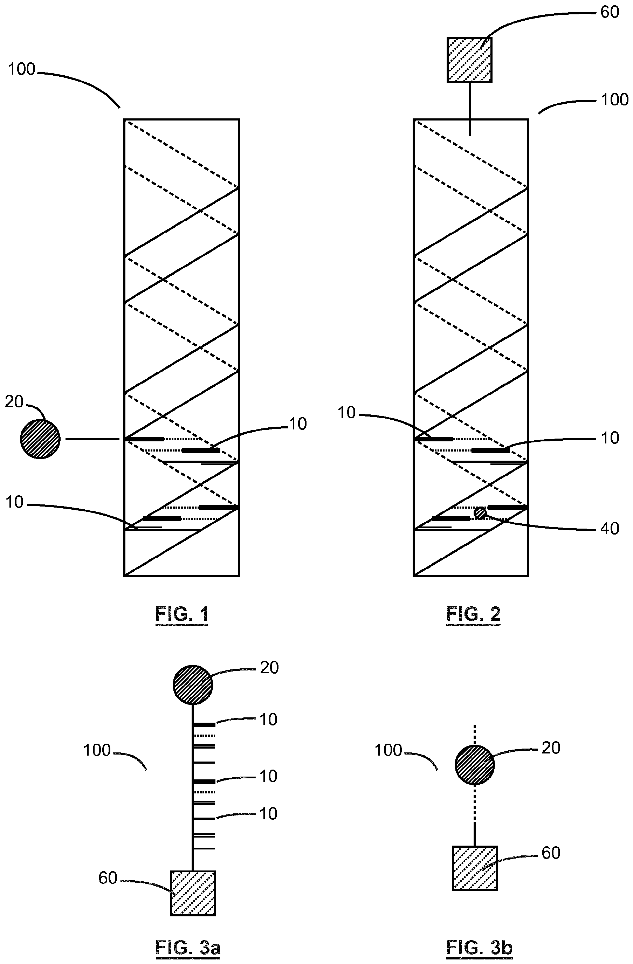

La **figure 1** illustre une vue schématique d'un double brin d'acide nucléique 100 modifié sur lequel a préalablement été greffée, en périphérie du double brin, sur la structure du brin d'acide nucléique, une nanoparticule 20 comprenant un composé métallique. On entend par métallique, qui comprend au moins un métal. Ce brin représente un acide nucléique de type ADN, ARN ou encore un analogue de l'acide nucléique. On appelle analogue de l'acide nucléique, un acide composé d'un squelette (ou polymère ou brin) formé d'une alternance de phosphates et de sucres, auquel squelette sont reliées des bases 10 azotées par l'intermédiaire du sucre, à raison d'une base 10 par sucre. On emploie le terme « métallisation » du brin d'acide nucléique 100 lorsque qu'une nanoparticule 20 comprenant un composé métallique est greffée en périphérie ou à l'extrémité de la structure du brin. Le pas de l'hélice est de l'ordre de 3 nanomètres et comporte, dans cet exemple, 10 paires de bases 10. L'enveloppe entourant le brin d'acide nucléique 100 est fictive. La nanoparticule 20 est, de préférence, choisie parmi un métal, un oxyde métallique, un nitrure, un carbure métallique. A titre d'exemple, on peut citer des métaux comme Cu, Ag, Au, Ru, Pt ; des oxydes des éléments Si, Cu, Al, Zr, Ti, Fe, Zn; des nitrures des éléments Ti, Ta, Hf, Mo, Si ; des carbures des éléments Si, Ti, Ta, W, Al, Fe. La nanoparticule 20 a un diamètre compris entre 1 nanomètre et 100 nanomètres.

La **figure 2** illustre une vue schématique d'un double brin d'acide nucléique 100 modifié sur lequel a été inséré, sur la structure du brin, un atome 40, comprenant un composé métallique, entre deux bases 10. On emploie dans ce cas le terme « metallation » du brin d'acide nucléique 100. L'atome 40 est de préférence choisi parmi le cuivre, le nickel, l'aluminium, le palladium, l'or, l'argent. Le brin d'acide nucléique 100 modifié au sein duquel a été greffé sur la structure du brin un atome 40 est de plus petite taille comparé à un brin d'acide nucléique 100 modifié possédant en périphérie une nanoparticule 20 greffée. Une fonction chimique 60, permettant de fixer le brin d'acide nucléique 100 modifié sur une surface tridimensionnelle spécifique, a été greffée en périphérie de la structure du brin. Selon un mode de configuration, cette fonction chimique 60 est greffée sur la structure d'un brin d'acide nucléique 100 modifié comprenant une ou plusieurs nanoparticule(s) 20 greffée(s) en périphérie de la structure du brin. Selon un autre mode de réalisation, un brin d'acide nucléique 100 comprend un ou plusieurs d'atomes 40 inséré(s) en son sein et/ou attaché(s) en la périphérie de la structure du brin ainsi qu'une fonction chimique 60 pour l'accrochage du brin sur une surface tridimensionnelle spécifique du substrat 200. A titre préféré, un brin d'acide nucléique 100 modifié comprend, sur sa structure, une ou plusieurs nanoparticule(s) 20, un ou plusieurs atome(s) 40 et au moins une fonction chimique 60.
La fonction chimique 60 est un groupement chimique (en anglais : « linker » et/ou « spacer ») pouvant d'une part se fixer sur le brin d'acide nucléique 100 modifié et d'autre part disposer d'un groupement d'atomes périphériques présentant soit une propriété hydrophile, soit une propriété hydrophobe. Il peut être avantageux d'avoir plusieurs fonctions chimiques 60 par brin d'acide nucléique 100, afin de faciliter le greffage sur le substrat 200 comme par exemple une fonction chimique 60 par extrémité.
Par ailleurs, l'hydrophilie peut être obtenue par un groupement chimique associé à la structure (ou squelette) du brin d'acide nucléide 100 ou intégré à celui-ci (autrement dit le squelette est lui-même hydrophile). Le double brin d'acide nucléique 100 est naturellement hydrophile en périphérie. Ainsi, on peut utiliser cette propriété intrinsèque pour le greffage sur des surfaces hydrophiles, sans avoir à ajouter une fonction chimique 60 spécifique ; celle-ci est naturellement intégrée au brin d'acide nucléique 100.

Les **figures 3A et 3B** illustrent des vues schématiques d'un simple brin d'acide nucléique 100 modifié sur lequel ont préalablement été greffées, à une de ses extrémités, sur la structure du brin d'acide nucléique 100, une nanoparticule 20 comprenant un composé métallique et à l'autre extrémité une fonction chimique 60. Le brin d'acide nucléique 100 est doté d'au moins une nanoparticule 20 et/ou un atome 40 ainsi que d'une fonction chimique 60 qui va permettre au brin d'acide nucléique 100 modifié de se greffer sur la surface d'accueil.

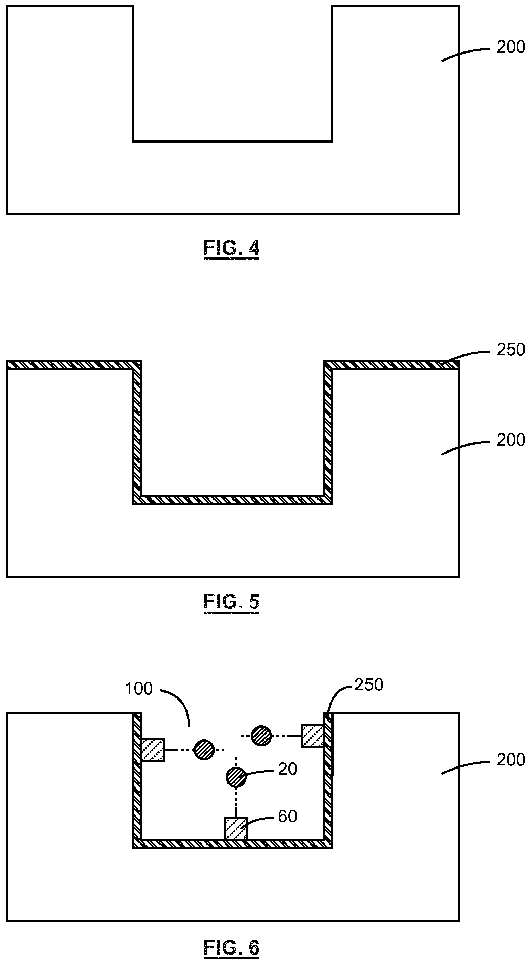

Les figures 4 à 8 illustrent un exemple de réalisation représentant l'enchainement des étapes technologiques pour l'intégration du revêtement 300 à base de métal sur une surface tridimensionnelle d'un substrat 200 en vue de la réalisation d'un via traversant. Cet exemple est purement illustratif. Notamment la surface tridimensionnelle peut comporter aussi bien des reliefs en crête qu'en creux à la surface du substrat 200.

La **figure 4** illustre l'étape de formation d'un motif d'interconnexion sur le substrat 200. Le motif est réalisé de sorte à former une cavité dans le substrat 200. Avantageusement, la cavité présente une profondeur supérieure à sa largeur. On entend par profondeur, une dimension suivant l'épaisseur du substrat 200. On entend par largeur, une dimension perpendiculaire à l'épaisseur du substrat 200. Selon un mode de réalisation, le motif forme un relief en surface du substrat 200. Le substrat 200, ou du moins la portion du substrat 200 dans laquelle le motif est formé, est préférentiellement choisi parmi un matériau semi-conducteur. Le substrat 200 est, de préférence, en silicium. Il peut être en verre ou en polymère. Pour un substrat 200 de silicium, l'étape de formation du motif d'interconnexion peut être effectuée par gravure ionique réactive profonde à l'aide d'un masque en SiO₂, par exemple. La gravure du substrat 200 pour former le motif d'interconnexion est de préférence anisotrope. La gravure du substrat 200 peut être sèche ou humide.

La **figure 5** illustre l'étape de traitement de la surface tridimensionnelle du substrat 200, ou du moins une portion de la surface, pour obtenir, par exemple un contraste hydrophile/hydrophobe. Cette étape est optionnelle sachant que certaines surfaces sont naturellement hydrophiles ou hydrophobes. En effet, la surface d'un substrat 200 de silicium est, par exemple, naturellement hydrophobe tandis que celle de l'oxyde de silicium est naturellement hydrophile.
Pour un substrat 200 ne possédant pas une nature hydrophile ou hydrophobe, une couche de greffage 250 peut être déposée sur le substrat 200. La couche de greffage 250 peut être déposée selon tout type de technique, par exemple, choisie parmi le dépôt chimique en phase vapeur, le dépôt physique en phase vapeur, le dépôt de couches atomiques ou encore le dépôt par jets moléculaires. Selon un mode de réalisation, la couche de greffage 250 comprend un matériau hydrophile tel qu'un oxyde métallique, comme par exemple le dioxyde de silicium (SiO₂), l'oxyde de titane (TiO₂) ou encore l'oxyde d'aluminium (Al₂O₃). Selon un autre mode de réalisation, la couche de greffage 250 comprend un matériau hydrophobe tel que l'hexamethyldisilazane (HMDS) couramment utilisé en microélectronique comme promoteur d'adhérence des résines de photolithographie ou un polymère fluoré comme celui utilisé en couche de passivation dans le procédé de gravure profonde de type DRIE. Notons que les composés de la famille des organosilanes peuvent être soit hydrophiles, soit hydrophobes. L'épaisseur de la couche de greffage 250 est préférentiellement comprise entre quelques dixièmes de nanomètres et 1 micron. Lorsque son épaisseur est suffisante et que les propriétés du matériau le permettent, la couche de greffage 250 peut aussi faire fonction de couche d'isolation électrique. La couche de greffage 250 peut être déposée sur toute la surface tridimensionnelle du substrat 200. A titre préféré, la couche de greffage 250 est déposée de façon sélective sur la surface tridimensionnelle du substrat 200 c'est-à-dire sur une portion seulement de la surface tridimensionnelle où les brins d'acide nucléique 100 modifiés doivent être déposés.

La **figure 6** illustre une étape de greffage, sur la surface tridimensionnelle du substrat 200, d'au moins un brin d'acide nucléique 100 modifié, comprenant au moins un atome 40 et/ou une nanoparticule 20 et au moins une fonction chimique 60, comme décrit précédemment dans les figures 1 et 2. On peut, de façon générale, définir les fonctions chimiques 60 en fonction de la nature de la surface (isolant, métal, etc.) sur laquelle on va venir déposer le brin d'acide nucléique 100 modifié. La fonction chimique 60 sera adaptée au traitement de la surface du substrat 200. Selon un mode de configuration où le substrat 200 présente une surface hydrophobe, la fonction chimique sera choisie de nature hydrophobe de sorte à coopérer et venir se fixer sur la surface tridimensionnelle du substrat 200. Selon un autre mode de réalisation où le substrat 200 présente une surface hydrophile, la fonction chimique 60 sera choisie de nature hydrophile de sorte à coopérer et venir se fixer sur la surface tridimensionnelle du substrat 200.
Selon un mode de réalisation où la surface tridimensionnelle du substrat 200 comporte une pluralité des portions de nature différente (c'est-à-dire soit hydrophile, soit hydrophobe), la fonction chimique 60 coopérera uniquement avec la ou les portions de la surface présentant la même nature qu'elle. Ainsi, la coopération entre une fonction chimique 60 et la surface tridimensionnelle du substrat 200 se fera de manière sélective sur la ou les portions choisie(s).

L'étape de greffage, sur la surface tridimensionnelle du substrat 200, d'au moins un brin d'acide nucléique 100 modifié, comprenant au moins un atome 40 et/ou une nanoparticule 20 et au moins une fonction chimique 60, est obtenue par la mise en contact de la surface du substrat 200 avec un bain comprenant au moins un brin d'acide nucléique 100 modifié. Le bain est avantageusement une solution aqueuse de concentration en brins d'acide nucléique 100 comprise entre environ 10⁻¹² et 10⁻⁶ mole/litre. Le substrat 200 est plongé à température ambiante dans le bain pendant le temps nécessaire, d'une durée par exemple comprise entre 1 minute et quelques heures, pour greffer au moins un brin d'acide nucléique 100 modifié sur les portions pré-traitées de la surface tridimensionnelle du substrat 200. Selon la concentration de brins d'acide nucléique 100 dans la solution et le nombre de nanoparticules 20 et/ou d'atomes 40 insérés sur la structure des brins d'acide nucléique 100, on obtient une épaisseur de revêtement 300 à base de métal, par exemple, comprise entre une épaisseur minimale qui est de l'ordre de la taille de la nanoparticule 20 ou de la longueur ou du diamètre des brins d'acide nucléique 100 pour atteindre une épaisseur maximale de quelques centaines de nanomètres.
Afin d'augmenter la densité surfacique en nanoparticules 20 et/ou en atomes 40 sur la surface tridimensionnelle du substrat 200, on utilisera avantageusement un mélange de brins d'acide nucléique 100 modifiés comportant des structures de brins (ou squelettes) de longueurs différentes et/ou des tailles de nanoparticules 20 et/ou d'atomes 40 différentes, ou on greffera en premier les brins d'acide nucléique 100 modifiés avec les nanoparticules 20 de plus grande taille. Selon un autre mode de réalisation, on greffera d'abord les brins d'acide nucléique 100 modifiés comprenant des atomes 40, puis les brins d'acide nucléique 100 modifiés comprenant les nanoparticules 20, ou inversement. A titre préféré, le bain comprend à la fois des brins d'acide nucléique 100 modifiés pourvus d'atomes 40 et des brins d'acide nucléique 100 modifiés pourvus de nanoparticules 20.
Dans un cas particulier, on peut choisir un mélange d'un couple comprenant au moins un premier brin d'acide nucléique 100 modifié comportant une structure de brin ou un squelette équipé d'au moins une nanoparticule 20 à base d'un métal M1 et au moins un second brin d'acide nucléique 100 modifié comportant un squelette, qui peut être de taille différente du premier, équipé d'au moins une nanoparticule 20 à base d'un métal M2. On peut ainsi à partir de ce mélange déposer un matériau composite formé de nanoparticules 20 M1 et M2. Un composite dans l'invention est par exemple un mélange de métal, d'oxyde, de carbure et/ou de nitrure de métal. Lorsque M1 et M2 sont des métaux, on peut ainsi former un alliage métallique. Il est aussi possible de réaliser un alliage métallique lorsque les deux brins d'acide nucléique 100 modifiés comportent des atomes 40 métalliques respectivement M1 et M2. Lorsque M1 et M2 sont par exemple et respectivement un métal et un composé métallique de type oxyde, nitrure, ou carbure, on peut former un matériau composite dont les propriétés physiques, telles que par exemple la conductivité électrique ou thermique et/ou le coefficient de dilatation, dépendent de la composition en matériau M1 et en matériau M2.
Dans une variante, on peut choisir M1 tel qu'il soit par exemple associé à un oxyde M1_{X}O_{Y} et M2 en tant que métal, tels qu'au contact les deux matériaux réagissent (sous l'action de la température, par exemple) pour former un premier métal M1 et un deuxième oxyde métallique M2_{Z}O_{T} (réalisé à partir du deuxième métal M2). Ainsi donc lorsqu'on dépose d'abord des premiers brins d'acide nucléique 100 modifiés comprenant le métal M2, puis des deuxièmes brins d'acide nucléique 100 modifiés comprenant l'oxyde métallique M1_{X}O_{Y}, on va pouvoir créer une bicouche composée du métal M1 sur l'isolant M2_{Z}O_{T}. Selon un exemple de réalisation, on choisira comme premier métal M1, le cuivre et comme deuxième métal M2, l'aluminium.

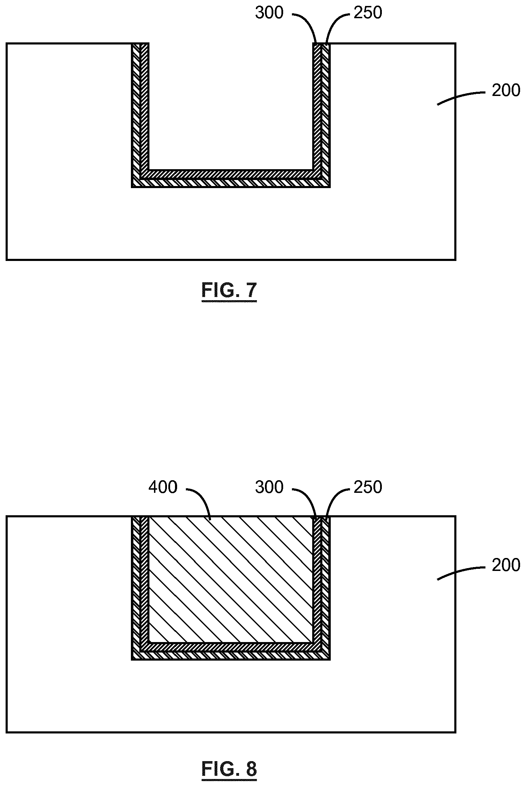

La **figure 7** illustre une étape de chauffage configurée pour détruire partiellement ou totalement la structure du brin d'acide nucléique 100 et/ou la fonction chimique 60 afin de favoriser la formation du revêtement 300 à base d'atomes 40 et/ou de nanoparticules 20 sur la surface tridimensionnelle du substrat 200. L'étape de destruction partielle ou totale de la structure du brin d'acide nucléique 100 et/ou de la fonction chimique 60 peut être réalisée à basse température, de préférence inférieure à 200°C. Afin de favoriser la coalescence ou l'agrégation des nanoparticules 20 à base de métal et/ou des atomes 40 métalliques, un recuit peut être réalisé à une température comprise entre 200°C et 450°C, voire à plus haute température compatible avec le budget thermique admissible et inférieur à environ 800°C. Afin de densifier le revêtement 300 à base de métal, l'étape de greffage de brin d'acide nucléique 100 modifié ainsi que l'étape de chauffage peuvent être répétées.
Selon un mode de réalisation où l'on souhaite ensuite déposer un métal, on réalise après le revêtement 300 obtenu par le greffage de brins d'acide nucléique 100 modifiés, un dépôt par voie chimique (en anglais « electroless »). Par exemple, de l'or pourrait être déposé sur des nanoparticules 20 d'or ; le revêtement 300 à base de métal étant préalablement formé à partir des nanoparticules 20.

La **figure 8** illustre l'étape de réalisation d'un dépôt électrochimique (En anglais « Electrochemical Déposition », ECD) sur le revêtement 300 à base de métal.
La figure 8 illustre une vue en coupe selon l'état de l'art d'un via traversant de type TSV rempli selon les procédés actuels. Dans les procédés basés sur l'utilisation d'un substrat 200 de silicium, la succession d'étapes consistant en la réalisation d'un via traversant comprend à l'issue de l'étape de gravure du substrat 200, de l'étape de dépôt d'un isolant, et de l'étape de dépôt d'une couche barrière à la diffusion du métal (par exemple, du cuivre), une étape consistant à recouvrir et/ou remplir le via par un conducteur électrique (par exemple, du cuivre), généralement par électro-déposition. Une étape de polissage mécano-chimique peut être effectuée à l'issue de cet enchainement en vue d'éliminer le métal en excès en surface du substrat 200. Ainsi, le via traversant débouchera sur une première face du substrat 200 à partir de laquelle la gravure de la cavité est réalisée. Le via traversant sera obtenu après amincissement d'une deuxième face du substrat 200, opposée à la première face.

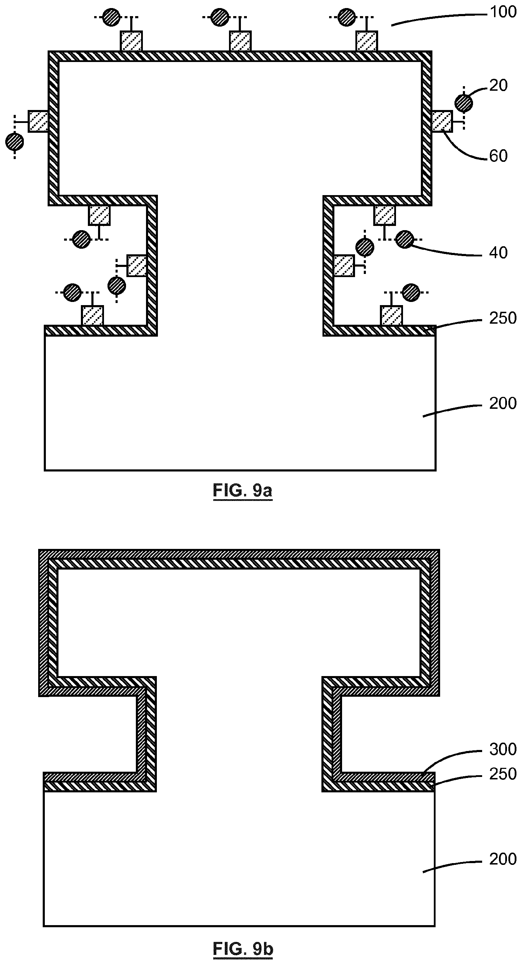

Les **figures 9A et 9B** illustrent un exemple de surface tridimensionnelle sur lequel le revêtement 300 à base de métal selon la présente invention peut être réalisé en assurant une uniformité de la couche et une répartition sur toute la surface tridimensionnelle du substrat 200. La plupart des méthodes traditionnelles de dépôt (de type CVD, ALD, PVD, etc.) ne permettent pas de réaliser un dépôt uniforme sur des motifs. Il s'avère effectivement difficile de former un revêtement uniforme sur une surface tridimensionnelle présentant des motifs en creux et/ou en relief. De manière particulièrement avantageuse, le procédé selon l'invention permettra de réaliser un revêtement 300 à base de métal uniforme épousant parfaitement la topographie de la surface tridimensionnelle du substrat 200.
Sur la figure 9A, les brins d'acide nucléique 100 modifiés, comprenant au moins une nanoparticule 20 et/ou un atome 40 et au moins une fonction chimique 60, se sont fixés uniquement sur les portions de la surface du substrat 200 hydrophiliques ou hydrophobiques pré-traitées ou sur la couche de greffage 250 de la surface tridimensionnelle du substrat 200.
La figure 9B illustre le revêtement 300 obtenue après greffage des brins d'acide nucléique 100 modifiés sur les portions pré-traitées de la surface tridimensionnelle du substrat 200. Avantageusement, le revêtement 300 à base de métal recouvre tous les flancs et les angles de la surface tridimensionnelle du substrat 200 selon une même épaisseur et une même uniformité.

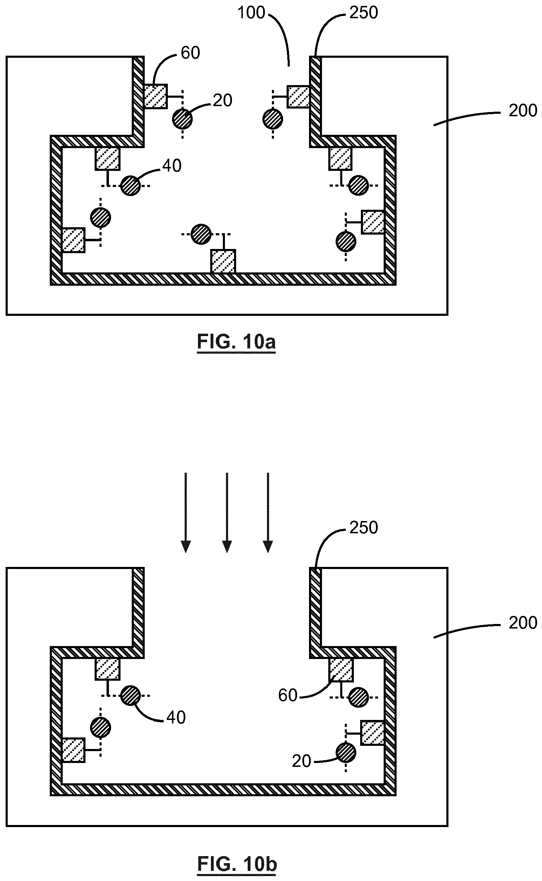

La **figure 10A** illustre un exemple de surface tridimensionnelle d'un substrat 200 sur lequel a été préalablement réalisée une cavité. Les flancs de la cavité sont recouverts d'un film hydrophile ou hydrophobe, soit de la couche de greffage 250, permettant aux brins d'acide nucléique 100 modifiés comprenant au moins une nanoparticule 20 et/ou au moins un atome 40 et au moins une fonction chimique 60, de venir se fixer. Avantageusement, à l'issue du procédé selon l'invention, le revêtement 300 à base de métal est déposé sur tous les flancs de la cavité formée dans le substrat 200.

**La** **figure 10B** illustre un exemple de surface tridimensionnelle d'un substrat 200 sur lequel a été préalablement réalisée une cavité. Afin de faire un dépôt localisé sur une portion sélective du substrat 200, un masque peut avantageusement être réalisé par le surplomb au-dessus de la cavité formée dans le substrat 200. Suite à une irradiation par rayons ultra-violets, seuls les flancs de la cavité protégés des rayons sont recouverts de brins d'acide nucléique 100 modifiés. Quand une surface est exposée à un rayonnement ultraviolet, elle a tendance à devenir hydrophile. Ainsi, selon un mode de réalisation où la surface tridimensionnelle du substrat 200 est naturellement ou pré-traitée de sorte à être hydrophobe, les fonctions chimiques 60 choisies de nature hydrophobe, viendront se fixer sur les portions hydrophobes de la surface tridimensionnelle. Les portions, exposées au rayonnement ultraviolet, devenues hydrophiles, ne pourront plus coopérer avec les fonctions chimiques 60 et, par conséquent, les brins d'acide nucléique 100 modifiés ne pourront se déposer sur les portions exposées. Avantageusement, ce mode de réalisation permet de réaliser un greffage sélectif sous irradiation par rayons ultra-violets. Selon un autre mode de réalisation où la surface tridimensionnelle du substrat 200 est naturellement ou pré-traitée de sorte à être hydrophobe et les fonctions chimiques 60 choisies de nature hydrophile, certaines portions hydrophobes de la surface du substrat 200, après irradiation par rayonnement ultraviolet deviendront hydrophiles et pourront donc coopérer avec les fonctions chimiques 60 également hydrophiles.

La présente invention permet de réaliser un revêtement métallique 300 ou isolant sur une surface tridimensionnelle comprenant des monocouches de nanoparticules 20 à base de métal et/ou d'atomes 40 métalliques. Un des avantages de la présente invention consiste en l'utilisation d'une voie humide pour réaliser le dépôt, favorisant un dépôt uniforme et continu sur une surface tridimensionnelle du substrat 200.

Il apparaît donc qu'il est possible de déposer des nanoparticules 20 à base de métal (or, nickel, par exemple) ou isolantes (SiO₂, TiO₂, par exemple) sur une surface hydrophile ou une surface hydrophobe. La technique apparaît très versatile et pourrait donc permettre de greffer tout type de nanoparticules 20 sur tout type de surface, avec dans certains cas, la possibilité de localiser le dépôt sous irradiation ultra-violet au travers d'un masque de photolithographie.

La dimension des brins d'acide nucléique 100, de l'ordre du nanomètre, permet, de manière particulièrement avantageuse, de pénétrer dans des cavités de fort facteur de forme. Compte tenu de la dimension du brin, il apparaît donc possible de disposer d'un gabarit nanométrique pour positionner des nanoparticules 20 ou des atomes 40 sur des surfaces avec relief et notamment des vias traversants de facteur de forme élevé, s'approchant de 50 :1.
De manière particulièrement avantageuse, il est possible, sous l'action d'un champ magnétique, de déposer sélectivement et de façon dirigée des brins d'acide nucléique 100 modifiés comportant au moins une nanoparticule 20 ferromagnétique. Un matériau ferromagnétique, lorsqu'il est plongé dans un champ magnétique, génère un nouveau champ magnétique au sein de celui-ci. Ce phénomène est plus communément appelé aimantation.

Le procédé selon la présente invention ouvre la porte à l'intégration tridimensionnelle de haute densité. Cette invention permet de réaliser collectivement des dépôts en 3D (voire en 2D également) sur des substrats 200 de type silicium ou oxyde de silicium ou à base de silice. Elle permet notamment de réaliser des vias traversants TSV de haute densité dans des substrats où il est nécessaire de connecter électriquement les substrats entre eux. Elle s'applique à la fabrication de systèmes microélectroniques. Selon l'invention, on entend par microélectronique l'ensemble des techniques de microélectronique et de nanoélectronique. Outre les applications de dépôt de revêtements ou de couches décrites ci-dessus, les structures multicouches selon l'invention peuvent avantageusement être utilisées sous forme de capacités comme accumulateurs d'énergie ou éléments de filtrage dans de nombreux produits électroniques comme les alimentations électriques intégrées, les amplificateurs de signaux, les filtres de circuits radiofréquences (RF) et pour toutes sortes d'applications domestiques, ou par l'industrie automobile et celle des télécommunications où la miniaturisation amène des avantages de fiabilité et une réduction des coûts. Les dispositifs que l'on peut former peuvent s'inscrire dans des systèmes du type systèmes micro-électro-mécaniques dits MEMS et/ou optiques.

La présente invention n'est pas limitée aux modes de réalisation précédemment décrits mais s'étend à tout mode de réalisation couvert par les revendications. L'invention ne s'applique pas uniquement à une surface tridimensionnelle mais également à une surface bidimensionnelle.

## Revendications

1. Procédé de réalisation d'un revêtement à base de métal (300) sur au moins une portion de la surface d'un substrat (200) d'un dispositif microélectronique, le procédé comprenant, à partir d'un brin d'acide nucléique (100) modifié comprenant une structure de brin d'acide nucléique, au moins une nanoparticule (20) à base de métal et/ou un atome (40) métallique et au moins une fonction chimique (60), au moins une étape de fixation du brin d'acide nucléique (100) modifié sur la portion de la surface du substrat (200) ; ladite portion de la surface du substrat (200) étant une surface tridimensionnelle sous forme d'une cavité ;
**caractérisé en ce que** le procédé comporte plusieurs étapes de fixation de brins d'acide nucléique (100) modifiés.

2. Procédé selon la revendication précédente dans lequel l'étape de fixation du brin d'acide nucléique (100) modifié est réalisée par l'intermédiaire de la fonction chimique (60).

3. Procédé selon la revendication 1 ou 2 dans lequel le procédé comporte une étape de destruction au moins partielle de la structure de brin d'acide nucléique (100) et/ou de la fonction chimique (60).

4. Procédé selon la revendication précédente dans lequel l'étape de destruction au moins partielle de la structure de brin d'acide nucléique (100) et/ou de la fonction chimique (60) comprend une étape de chauffage configurée de sorte à détruire partiellement ou totalement la structure de brin d'acide nucléique (100) et/ou de la fonction chimique (60).

5. Procédé selon l'une quelconque des revendications précédentes dans lequel la cavité présente une profondeur supérieure à sa largeur.

6. Procédé selon l'une quelconque des revendications précédentes dans lequel l'étape de fixation du au moins un brin d'acide nucléique (100) modifié sur la portion de la surface du substrat (200) est obtenue par la mise en contact de la surface du substrat (200) avec un bain comprenant au moins un brin d'acide nucléique (100) modifié.

7. Procédé selon l'une quelconque des revendications précédentes dans lequel la portion de la surface du substrat (200) comprend un groupement chimique configuré de sorte à coopérer avec la fonction chimique (60) fixée sur la structure du au moins un brin d'acide nucléique (100).

8. Procédé selon l'une quelconque des revendications précédentes dans lequel les brins d'acide nucléique (100) modifiés utilisés dans les différentes étapes de fixation sont identiques ou différents par la structure de leurs brins respectifs et/ou par leurs fonctions chimiques (60) respectives et/ou par la nature et/ou les dimensions des nanoparticules (20) à base de métal et/ou des atomes (40) métalliques.

9. Procédé selon l'une quelconque des revendications précédentes comportant, après les étapes de fixation de brins d'acide nucléique (100) modifiés, une seule étape de destruction des structures de brins d'acide nucléique (100).

10. Procédé selon l'une quelconque des revendications précédentes comprenant, préalablement à ladite au moins une étape de fixation du au moins un brin d'acide nucléique modifié (100) sur la portion de la surface du substrat (200), une étape de dépôt d'une couche de greffage (250) sur au moins la portion de la surface du substrat (200).

11. Procédé selon l'une quelconque des revendications précédentes dans lequel la portion de la surface du substrat (200) ou la couche de greffage (250) comprend un matériau hydrophile ou hydrophobe.

12. Procédé selon l'une quelconque des revendications précédentes dans lequel la fonction chimique (60) est un groupement d'atomes hydrophile ou hydrophobe.

13. Procédé selon l'une quelconque des revendications précédentes dans lequel le revêtement à base de métal (300) fait partie d'un via.

14. Procédé selon l'une quelconque des revendications précédentes dans lequel l'atome (40) métallique est choisi parmi le cuivre, le nickel, l'aluminium, le palladium, l'or, l'argent.

15. Procédé selon l'une quelconque des revendications précédentes dans lequel la nanoparticule (20) à base de métal est choisie parmi un métal, un oxyde métallique, un nitrure métallique, un carbure métallique.

16. Procédé selon l'une quelconque des revendications précédentes comprenant, préalablement à l'étape de fixation du au moins un brin d'acide nucléique (100) modifié sur la portion de la surface du substrat (200), une étape d'irradiation par rayons ultra-violets de la portion de la surface du substrat (200) destinée à recevoir le revêtement (300) à base de métal.

17. Procédé selon l'une quelconque des revendications précédentes comprenant, préalablement à l'étape de fixation du au moins un brin d'acide nucléique (100) modifié sur la portion de la surface du substrat (200), une étape d'irradiation par rayons ultra-violets de toute la surface du substrat (200), exceptée la portion de la surface destinée à recevoir le revêtement (300) à base de métal.

18. Procédé selon l'une quelconque des revendications précédentes dans lequel le brin d'acide nucléique (100) modifié comprend au moins une nanoparticule (20) à base de métal, ledit métal étant un métal ferromagnétique, ladite nanoparticule (20) étant configurée pour former, sous l'action d'un champ magnétique, un revêtement (300) à base de métal ferromagnétique sur une portion de la surface d'un substrat (200).

19. Procédé selon l'une quelconque des revendications précédentes dans lequel :
- au moins un premier brin d'acide nucléique (100) modifié comprenant au moins une première nanoparticule (20) à base de métal et/ou un premier atome (40) métallique,
- et au moins un deuxième brin d'acide nucléique (100) modifié comprenant au moins une deuxième nanoparticule (20) à base de métal et/ou un deuxième atome (40) métallique,
sont configurés de sorte à ce que la première et/ou la deuxième nanoparticule(s) (20) et le premier et/ou le deuxième atome(s) (40) métallique(s) forment un revêtement (300) à base d'un alliage métallique ou d'un composite sur une portion de la surface d'un substrat (200).

20. Procédé selon l'une quelconque des revendications précédentes dans lequel :
- au moins un premier brin d'acide nucléique (100) modifié comprenant au moins une première nanoparticule (20) à base d'un premier métal,
- et au moins un deuxième brin d'acide nucléique (100) modifié comprenant au moins une deuxième nanoparticule (20) à base d'un deuxième métal,
sont configurés de sorte à ce que la première et la deuxième nanoparticules (20) forment un revêtement (300) bi-couche composé d'un dépôt à base du premier métal de la première nanoparticule (20) recouvert par un dépôt du deuxième métal de la deuxième nanoparticule (20) sur une portion de la surface d'un substrat (200).

21. Procédé selon l'une quelconque des revendications précédentes dans lequel l'au moins une nanoparticule (20) a un diamètre compris entre 1 nanomètre et 100 nanomètres.

## Patentansprüche

1. Verfahren zur Herstellung einer Beschichtung auf Metallbasis (300) auf zumindest einem Abschnitt der Oberfläche eines Substrats (200) einer mikroelektronischen Vorrichtung, wobei das Verfahren, ausgehend von einem modifizierten Nukleinsäurestrang (100), eine Nukleinsäurestrangstruktur umfassend, zumindest ein Nanopartikel (20) auf Metallbasis und/ oder ein Metallatom (40) und eine chemische Funktion (60), zumindest einen Schritt zur Fixierung des modifizierten Nukleinsäurestrangs (100) auf dem Abschnitt der Oberfläche des Substrats (200) umfasst; wobei der besagte Abschnitt der Oberfläche des Substrats (200) eine dreidimensionale Oberfläche in Form einer Vertiefung ist;
**dadurch gekennzeichnet, dass** das Verfahren mehrere Schritte zur Fixierung des modifizierten Nukleinsäurestrangs (100) umfasst.

2. Verfahren nach dem vorhergehenden Anspruch, wobei der Schritt zur Fixierung des modifizierten Nukleinsäurestrangs (100) anhand der chemischen Funktion (60) durchgeführt wird.

3. Verfahren nach Anspruch 1 oder 2, wobei das Verfahren einen Schritt zur zumindest teilweisen Zerstörung der Nukleinsäurestrangstruktur (100) und/ oder der chemischen Funktion (60) umfasst.

4. Verfahren nach dem vorhergehenden Anspruch, wobei der Schritt zur zumindest teilweisen Zerstörung der Nukleinsäurestrangstruktur (100) und/ oder der chemischen Funktion (60) einen Heizschritt umfasst der derart konfiguriert ist, um die Nukleinsäurestrangstruktur (100) und/ oder die chemische Funktion (60) teilweise oder vollkommen zu zerstören.

5. Verfahren nach irgendeinem der vorhergehenden Ansprüche, wobei die Vertiefung eine Tiefe aufweist, die größer ist, als ihre Breite.

6. Verfahren nach irgendeinem der vorhergehenden Ansprüche, wobei man den Schritt zur Fixierung des zumindest einen modifizierten Nukleinsäurestrangs (100) auf dem Abschnitt der Oberfläche des Substrats (200) durch die Kontaktierung der Oberfläche des Substrats (200) mit einem Bad erhält, das zumindest einen modifizierten Nukleinsäurestrang (100) umfasst.

7. Verfahren nach irgendeinem der vorhergehenden Ansprüche, wobei der Abschnitt der Oberfläche des Substrats (200) eine chemische Gruppe umfasst, die derart konfiguriert ist, um mit der chemischen Funktion (60) zusammenzuwirken, die auf der Struktur des zumindest einen Nukleinsäurestrangs (100) fixiert ist.

8. Verfahren nach irgendeinem der vorhergehenden Ansprüche, wobei die modifizierten Nukleinsäurestränge (100), die in den verschiedenen Schritten zur Fixierung verwendet werden, identisch sind oder sich durch die Struktur ihrer jeweiligen Stränge und/ oder ihre jeweiligen chemischen Funktionen (60) und/ oder durch die Art und/ oder die Abmessungen der Nanopartikel (20) auf Metallbasis und/ oder der Metallatome (40) unterscheiden.

9. Verfahren nach irgendeinem der vorhergehenden Ansprüche, nach den Schritten zur Fixierung von modifizierten Nukleinsäuresträngen (100) einen einzigen Schritt zur Zerstörung der Nukleinsäurestrangstrukturen (100) umfassend.

10. Verfahren nach irgendeinem der vorhergehenden Ansprüche, vor dem besagten zumindest einen Schritt zur Fixierung des zumindest einen modifizierten Nukleinsäurestrangs (100) auf dem Abschnitt der Oberfläche des Substrats (200) einen Schritt zur Abscheidung einer Pfropfungsschicht (250) auf zumindest dem Abschnitt der Oberfläche des Substrats (200) umfassend.

11. Verfahren nach irgendeinem der vorhergehenden Ansprüche, wobei der Abschnitt der Oberfläche des Substrats (200) oder die Pfropfungsschicht (250) ein wasseranziehendes oder wasserabweisendes Material umfasst.

12. Verfahren nach irgendeinem der vorhergehenden Ansprüche, wobei die chemische Funktion (60) eine Gruppe von wasseranziehenden oder wasserabweisenden Atomen ist.

13. Verfahren nach irgendeinem der vorhergehenden Ansprüche, wobei die Beschichtung auf Metallbasis (300) zu einer Durchkontaktierung gehört.

14. Verfahren nach irgendeinem der vorhergehenden Ansprüche, wobei das Metallatom (40) aus Kupfer, Nickel, Aluminium, Palladium, Gold oder Silber ausgewählt wird.

15. Verfahren nach irgendeinem der vorhergehenden Ansprüche, wobei das Nanopartikel (20) auf Metallbasis aus einem Metall, einem Metalloxyd, einem Metallnitrid, einem Metallkarbid ausgewählt wird.

16. Verfahren nach irgendeinem der vorhergehenden Ansprüche, vor dem Schritt zur Fixierung des zumindest einen modifizierten Nukleinsäurestrangs (100) auf dem Abschnitt der Oberfläche des Substrats (200) einen Schritt zur Bestrahlung mit UV-Strahlen des Abschnitts der Oberfläche des Substrats (200) umfassend, der dazu bestimmt ist, die Beschichtung auf Metallbasis (300) zu empfangen.

17. Verfahren nach irgendeinem der vorhergehenden Ansprüche, vor dem Schritt zur Fixierung des zumindest einen modifizierten Nukleinsäurestrangs (100) auf dem Abschnitt der Oberfläche des Substrats (200) einen Schritt zur Bestrahlung mit UV-Strahlen der gesamten Oberfläche des Substrats (200), mit Ausnahme des Abschnitts der Oberfläche umfassend, der dazu bestimmt ist, die Beschichtung auf Metallbasis (300) zu empfangen.

18. Verfahren nach irgendeinem der vorhergehenden Ansprüche, wobei der modifizierte Nukleinsäurestrang (100) zumindest ein Nanopartikel (20) auf Metallbasis umfasst, wobei das besagte Metall ein ferromagnetisches Metall ist, wobei das besagte Nanopartikel (20) konfiguriert ist, um unter der Einwirkung eines Magnetfeldes eine Beschichtung (300) auf Basis eines ferromagnetischen Metalls auf einem Abschnitt der Oberfläche eines Substrats (200) zu bilden.

19. Verfahren nach irgendeinem der vorhergehenden Ansprüche, wobei:
- zumindest ein erster modifizierter Nukleinsäurestrang (100), der zumindest ein erstes Nanopartikel (20) auf Metallbasis und/ oder ein erstes Metallatom (40) umfasst,
- und zumindest ein zweiter modifizierter Nukleinsäurestrang (100), der zumindest ein zweites Nanopartikel (20) auf Metallbasis und/ oder ein zweites Metallatom (40) umfasst,
konfiguriert sind, sodass das erste und/ oder das zweite Nanopartikel (20) und das erste und/ oder das zweite Metallatom (40) eine Beschichtung (300) auf Basis einer Metalllegierung oder eines Verbundstoffes auf einem Abschnitt der Oberfläche eines Substrats (200) bilden.

20. Verfahren nach irgendeinem der vorhergehenden Ansprüche, wobei:
- zumindest ein erster modifizierter Nukleinsäurestrang (100), der zumindest ein erstes Nanopartikel (20) auf Basis eines ersten Metalls umfasst,
- und zumindest ein zweiter modifizierter Nukleinsäurestrang (100), der zumindest ein zweites Nanopartikel (20) auf Basis eines zweiten Metalls umfasst,
konfiguriert sind, sodass das erste und das zweite Nanopartikel (20) eine doppelschichtige Beschichtung (300) bilden, die sich aus einer Abscheidung auf Basis des ersten Metalls des ersten Nanopartikels (20) zusammensetzt, die durch eine Abscheidung des zweiten Metalls des zweiten Nanopartikels (20) auf einem Abschnitt der Oberfläche eines Substrats (200) bedeckt wird.

21. Verfahren nach irgendeinem der vorhergehenden Ansprüche, wobei zumindest ein Nanopartikel (20) einen Durchmesser zwischen 1 Nanometer und 100 Nanometern aufweist.

## Claims

1. Method for producing a metal coating (300) on at least one portion of the surface of a substrate (200) of a microelectronic device, with the method comprising, from a modified strand of nucleic acid (100) comprising a strand of nucleic acid structure, at least one metal nanoparticle (20) and/or a metal atom (40) and at least one chemical function (60), at least one step of attaching the modified strand of nucleic acid (100) on the portion of the surface of the substrate (200); said portion of the surface of the substrate (200) being a three-dimensional surface in the form of a cavity;
**characterized in that** the method comprises several steps of attaching modified strands of nucleic acid (100).

2. Method as claimed in the preceding claim wherein the step of attaching the modified strand of nucleic acid (100) is carried out by the intermediary of the chemical function (60).

3. Method according to claim 1 or 2 wherein the method comprises a step of destroying at least partially the strand of nucleic acid structure (100) and/or the chemical function (60).

4. Method according to the preceding claim wherein the step of destroying at least partially the strand of nucleic acid structure (100) and/or the chemical function (60) comprises a step of heating configured in such a way as to partially or entirely destroy the strand of nucleic acid structure (100) and/or the chemical function (60).

5. Method according to any preceding claim wherein the cavity has a depth greater than its width.

6. Method according to any preceding claim wherein the step of attaching the at least one modified strand of nucleic acid (100) on the portion of the surface of the substrate (200) is obtained by the putting into contact of the surface of the substrate (200) with a bath comprising at least one modified strand of nucleic acid (100).

7. Method according to any preceding claim wherein the portion of the surface of the substrate (200) comprises a chemical group configured in such a way as to cooperate with the chemical function (60) attached to the structure of the at least one strand of nucleic acid (100).

8. Method according to any preceding claim wherein the modified strands of nucleic acid (100) used in the various steps of attaching are identical or different through the structure of their respective strands and/or through their respective chemical functions (60) and/or through the nature and/or the dimensions of the metal nanoparticles (20) and/or metal atoms (40).

9. Method according to any preceding claim comprising, after the steps of attaching of modified strands of nucleic acid (100), a single step of destroying strands of nucleic acid structures (100).

10. Method according to any preceding claim comprising, prior to said at least one step of attaching the at least one modified strand of nucleic acid (100) on the portion of the surface of the substrate (200), a step of deposition of a graft layer (250) on at least the portion of the surface of the substrate (200).

11. Method according to any preceding claim wherein the portion of the surface of the substrate (200) or the graft layer (250) comprises a hydrophilic or hydrophobic material.

12. Method according to any preceding claim wherein the chemical function (60) is a hydrophilic or hydrophobic group of atoms.

13. Method according to any preceding claim wherein the metal coating (300) is part of a via.

14. Method according to any preceding claim wherein the metal atom (40) is chosen from copper, nickel, aluminum, palladium, gold, silver.

15. Method according to any preceding claim wherein the metal nanoparticle (20) is chosen from a metal, a metal oxide, a metal nitride, a metal carbine.

16. Method according to any preceding claim comprising, prior to the step of attaching the at least one modified strand of nucleic acid (100) on the portion of the surface of the substrate (200), a step of radiating via ultraviolet rays of the portion of the surface of the substrate (200) intended to receive the metal coating (300).

17. Method according to any preceding claim comprising, prior to the step of attaching the at least one modified strand of nucleic acid (100) on the portion of the surface of the substrate (200), a step of radiating via ultraviolet rays of the entire surface of the substrate (200), except the portion of the surface intended to receive the metal coating (300).

18. Method according to any preceding claim wherein the modified strand of nucleic acid (100) comprises at least one metal nanoparticle (20), said metal being a ferromagnetic metal, said nanoparticle (20) being configured to form, under the action of a magnetic field, a ferromagnetic metal coating (300) on a portion of the surface of a substrate (200).

19. Method according to any preceding claim wherein:
- at least one first modified strand of nucleic acid (100) comprising at least one first metal nanoparticle (20) and/or a first metal atom (40),
- and at least one second modified strand of nucleic acid (100) comprising at least one second metal nanoparticle (20) and/or a second metal atom (40),
are configured in such a way that the first and/or the second nanoparticle(s) (20) and the first and/or the second metal atom(s) (40) form a metal alloy or composite coating (300) on a portion of the surface of a substrate (200).

20. Method according to any preceding claim wherein:
- at least one first modified strand of nucleic acid (100) comprising at least one first nanoparticle (20) with a first metal base,
- and at least one second modified strand of nucleic acid (100) comprising at least one second nanoparticle (20) with a second metal base,
are configured in such way that the first and the second nanoparticles (20) form a two-layer coating (300) comprised of a deposition of the first metal of the first nanoparticle (20) covered by a deposition of the second metal of the second nanoparticle (20) on a portion of the surface of a substrate (200).

21. Method according to any preceding claim wherein the at least one nanoparticle (20) has a diameter between 1 nanometer and 100 nanometers.
